# EUROPEAN PATENT APPLICATION

(11) **EP 4 585 727 A1**
(43) Date of publication of application: **16.07.2025**
(21) Application number: 23905835.7
(22) Date of filing: 15.12.2023
(51) Int. Cl.: C30B 29/22, H01S 3/16

(54) **YELLOW LIGHT SELF-FREQUENCY DOUBLING CRYSTAL AND YELLOW LIGHT SELF-FREQUENCY DOUBLING LASER**

(30) Priority: 20.12.2022 CN 202211638539
(71) Applicant: Qingdao Lasence Group Co., Ltd, Qingdao, Shandong 266109 (CN); Shandong University, Jinan, Shandong 250100 (CN)
(72) Inventor: MA, Changqin, Qingdao, Shandong 266109 (CN); ZHANG, Huaijin, Qingdao, Shandong 266109 (CN); YU, Haohai, Qingdao, Shandong 266109 (CN); HAN, Xuekun, Qingdao, Shandong 266109 (CN)
(74) Representative: Chung, Hoi Kan
(86) International application number: PCT/CN2023/139165
(87) International publication number: WO 2024/131671

(57) **Abstract**

A yellow light self-frequency doubling crystal and a yellow light self-frequency doubling laser comprising the yellow light self-frequency doubling crystal, as well as a laser light source and a focusing or light transmission component. The yellow light self-frequency doubling crystal is a crystal doped with tetravalent cerium ions and trivalent ytterbium ions, the doping concentration of Ce⁴⁺being 0.1% to 12%, and the doping con- centration of Yb³⁺ being 1% to 40%.

## Description

### TECHNICAL FIELD

The present application relates to the technical field of laser line projectors, and in particular, to a self-frequency-doubling yellow crystal and a self-frequency doubling yellow laser.

### BACKGROUND

In recent years, yellow laser light has been playing an increasingly important role in fields such as laser medicine and national defense and military industries. Particularly, yellow lasers based on self-frequency-doubling laser crystals like Yb:YCOB have become one of the most important yellow light sources due to their compact size, simple structure, and suitability for mass production. This type of light source has extensive and significant applications in laser line projectors.

For example, a commercially available laser line projector in the prior art uses a yellow laser as its light source, which operates at 25°C and employs an 895-nm semiconductor pump source for pumping a Yb_{0.15}Y_{0.85}COB self-frequency-doubling crystal. The crystal is cut at an angle along a direction with a maximum nonlinear coefficient for 1140-nm frequency doubling, with both light transmission surfaces optically polished. The crystal device has dimensions of 1.3 mm x 1.3 mm x 2.0 mm, and both light transmission surfaces thereof are coated with optical films. The semiconductor pump source emits 895-nm infrared light, which enters the Yb:YCOB self-frequency-doubling crystal through a focusing lens, generating 570-nm yellow laser light.

However, existing yellow laser line projectors in the prior art have defects. Existing yellow laser line projectors using the Yb :YCOB self-frequency-doubling crystal have an extremely unstable light output power during the initial period of operation and require some time to stabilize; at the same time, the light output power of these projectors is significantly low during operation.

### SUMMARY

In order to solve at least one of the above technical problems and develop a laser line projector with a relatively stable yellow light output power from the beginning of operation, the present application provides a self-frequency-doubling yellow crystal and a self-frequency-doubling yellow laser.

In a first aspect, the present application provides a self-frequency-doubling yellow crystal doped with tetravalent cerium ions (Ce⁴⁺) at a doping concentration of 0.1% ~ 12% and trivalent ytterbium ions (Yb³⁺) at a doping concentration of 1% ~ 40%.

By adopting the aforementioned technical solution, the present application uses a crystal doped with elements cerium and ytterbium, which has a stable light output power without significant power attenuation, thereby effectively solving the problem of decrease in yellow light output power of a self-frequency-doubling crystal in the prior art.

Optionally, a ratio of the doping concentrations of the tetravalent cerium ions to the trivalent ytterbium ions is controlled within a range of 0.1% ~ 30%.

Optionally, a total doping concentration of the tetravalent cerium ions and the trivalent ytterbium ions is 5%, 10%, or 20%.

Optionally, the crystal is selected from one of yttrium calcium oxyborate crystal, gadolinium calcium oxyborate crystal, gadolinium yttrium calcium oxyborate crystal, yttrium aluminum garnet crystal, gadolinium gallium garnet crystal, yttrium aluminum borate crystal, or fiber optic crystal.

Further optionally, the crystal doped with the tetravalent cerium ions and the trivalent ytterbium ions is a yttrium calcium oxyborate crystal with a molecular formula of Ce⁴⁺ₓYb_{y}Y_{1-x-y}Ca₄O(BO₃)₃; a concentration x of the Ce⁴⁺ is 0.1% ~ 12%; a concentration y of the Yb³⁺ is 1% ~ 40%; and a total concentration of the Ce⁴⁺ and the Yb³⁺ is 0.1% ~ 30%.

In a second aspect, the present application provides a self-frequency-doubling yellow laser, including the aforementioned self-frequency-doubling yellow crystal, and further including a laser light source and a focusing or light transmission assembly.

By adopting the aforementioned technical solution, the present application uses a crystal doped with elements cerium and ytterbium as a self-frequency-doubling crystal to prepare a self-frequency-doubling yellow laser. The self-frequency-doubling yellow laser has a yellow light output power that not only suffers no significant decrease within the first 60 s of operation but also remains stable during operation; in addition, the luminous efficiency can be maintained at a relatively high level, thereby significantly improving the light output power and reducing energy consumption.

Optionally, the self-frequency-doubling yellow crystal is cut at an angle along a direction with a maximum nonlinear coefficient of output light.

Optionally, the laser light source is a semiconductor pump source with a wavelength of 880 nm ~ 1000 nm.

Optionally, an output wavelength of the laser is controlled within a range of 555 nm ~ 630 nm.

Optionally, the focusing or light transmission assembly is a focusing lens or optical fiber.

In summary, the present invention has at least one of the following beneficial technical effects:
1. the present application uses a crystal doped with elements cerium and ytterbium, which has a stable power without significant power attenuation, thereby effectively solving the problem of decrease in yellow light output power of a self-frequency-doubling crystal in the prior art;
2. the crystal of the present application has a stable light output power without significant power attenuation, and the self-frequency-doubling yellow laser prepared using the crystal has a yellow light output power that not only suffers no significant decrease within the first 60 s of operation but also remains stable during operation;
3. the luminous efficiency of the self-frequency-doubling yellow laser prepared according to the present application can be maintained at a relatively high level, thereby significantly improving the light output power and reducing energy consumption; and
4. the self-frequency-doubling yellow laser prepared according to the present application utilizes a specially designed crystal to maintain the luminous efficiency at a relatively high level without the need to add complex temperature control and angle adjustment mechanisms, thereby contributing to low manufacturing and use costs.

### BRIEF DESCRIPTION OF THE DRAWINGS

FIG. 1 is a monitoring diagram of light output power in an ion concentration experiment according to the present application;
FIG. 2 is a monitoring diagram of light output power in a comparative example according to the present application; and
FIG. 3 is a monitoring diagram of light output power in Example 1 according to the present application.

### DETAILED DESCRIPTION OF THE EMBODIMENTS

The present application will be further described in detail below in conjunction with embodiments.

The present application provides a self-frequency-doubling yellow crystal doped with tetravalent cerium ions (Ce⁴⁺) at a doping concentration of 0.1% ~ 12% and trivalent ytterbium ions (Yb³⁺) at a doping concentration of 1% ~ 40%.

At present, it is generally believed in the art that the luminous efficiency of a yellow laser line projector based on a self-frequency-doubling laser will not change significantly within a time period that does not cause significant changes in the thermal effect of the crystal. In order to prevent the impact of the thermal effect, existing technologies in the prior art usually apply effective heat dissipation measures to the crystal, which leads to the general belief among those skilled in the art that the luminous efficiency of the yellow laser line projector does not change over time. However, the applicant incidentally discovered during an experiment that the actual situation might not be as previously believed. By monitoring the light output power of commercially available yellow laser line projectors, the applicant found that the luminous efficiency remained basically unchanged only after the first 60 s of operation. Within the first 60 s of operation, the luminous efficiency undergoes a sharp change, initially decreasing rapidly over time and eventually stabilizing at a relatively low level.

Based on the above findings, the applicant conducted a detailed experimental study on the problems existing in the prior art. The applicant first verified whether the doping concentration of active ions in the laser crystal of the laser line protector decreased, specifically, whether the doping concentration of Yb³⁺ ions decreased with prolonged operation.

The applicant designed an experiment conducted at 25°C, where a 50-W 976-nm semiconductor pump source with a volume Bragg grating (VBG) was used to pump a Yb_{0.15}Y_{0.85}COB self-frequency-doubling crystal. The Yb_{0.15}Y_{0.85}COB self-frequency-doubling crystal was cut at an angle along a direction with a maximum nonlinear coefficient for 1020-nm frequency doubling, with both light transmission surfaces optically polished. The crystal device had dimensions of 2.0 mm x 2.0 mm x 6.0 mm, and both light transmission surfaces thereof were coated with optical films. The applicant adjusted the cavity mirror reflectance wavelength of the Yb_{0.15}Y_{0.85}COB laser to peak at 510 nm and then monitored changes in green light output power over time.

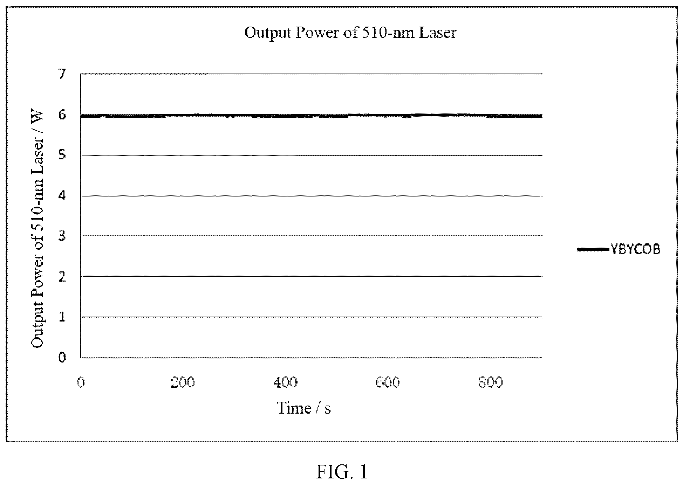

The experimental monitoring results are shown in FIG. 1. The green light output power was relatively stable and did not change significantly over time. Through the above experiment, it can be basically determined that the concentration of Yb³⁺ ions will not change over time.

Then, the applicant used a precise temperature control apparatus to maintain the crystal at a constant temperature throughout the process, ensuring that the frequency-doubling efficiency remained unchanged and preventing thermal lensing effects. However, in the experiment, the yellow light output power still exhibited a decrease. Based on the observation and after ruling out other potential causes, the applicant hypothesized that the decrease in yellow light output power was due to a reduction in the emission cross-section of yellow light over time, leading to a significant decrease in yellow light output power.

Based on the above experimental study, the applicant attempted various approaches to influence or modify the emission cross-section of yellow light, including adjusting crystal temperature, doping with other ions, and changing cutting directions. Through continuous attempts, the applicant ultimately discovered that only doping with Ce⁴⁺ ions could stabilize laser output and enhance optical conversion efficiency, while all other approaches failed to achieve similar or comparable effects. Even doping with Ce³⁺ ions did not contribute to stabilizing laser output, and the doping concentration of Ce⁴⁺ ions was found to have stringent requirements.

Based on the above experimental study, the applicant conducted detailed experiments on the doping concentration and designed the self-frequency-doubling yellow crystal of the present application.

The examples of the present application are as follows.

### Example 1

This example designed a self-frequency-doubling yellow crystal Ce⁴⁺_{0.01}Yb_{0.15}Y_{0.84}COB, based on which a yellow laser was designed. The crystal of the laser was cut at an angle along a direction with a maximum nonlinear coefficient for 1140-nm frequency doubling, with both light transmission surfaces optically polished. The crystal device had dimensions of 1.3 mm x 1.3 mm x 2.0 mm, and both light transmission surfaces thereof were coated with optical films. The laser used an 895-nm infrared semiconductor pump source, with a focusing lens arranged between the pump source and the self-frequency-doubling crystal for optical focusing. In this embodiment, the 895-nm infrared light emitted by the semiconductor pump source in this example was focused by the focusing lens and then entered the self-frequency-doubling crystal, generating 570-nm yellow laser light.

The present application also designed a variety of other self-frequency-doubling yellow crystals, and selected yttrium calcium oxyborate crystal, gadolinium calcium oxyborate crystal, gadolinium yttrium calcium oxyborate crystal, yttrium aluminum garnet crystal, gadolinium gallium garnet crystal, yttrium aluminum borate crystal, or fiber optic crystal. The doping concentration of Ce⁴⁺ was controlled within a range of 0.1% ~ 12%; the doping concentration of Yb³⁺ was controlled within a range of 1% ~ 40%; and the ratio of the doping concentrations of Ce⁴⁺ and Yb³⁺ was 1%, 5%, 10%, 20%, or 30% respectively.

The present application prepared a yellow laser using the above-designed multiple self-frequency-doubling yellow crystals. The self-frequency-doubling crystal of the laser was cut at an angle along a direction with a maximum nonlinear coefficient of output light. The laser light source was a semiconductor pump source with a wavelength of 880 nm ~ 1000 nm. The output wavelength of the laser was controlled within a range of 555 nm ~ 630 nm.

### Comparative Example

The present application used a commercially available yellow laser line projector as a comparative example.

The laser line projector employed an 895-nm semiconductor pump source and a Yb_{0.15}Y_{0.85}COB self-frequency-doubling crystal. The crystal was cut at an angle along a direction with a maximum nonlinear coefficient for 1140-nm frequency doubling, with both light transmission surfaces optically polished. The crystal device had dimensions of 1.3 mm x 1.3 mm x 2.0 mm, and both light transmission surfaces thereof were coated with optical films.

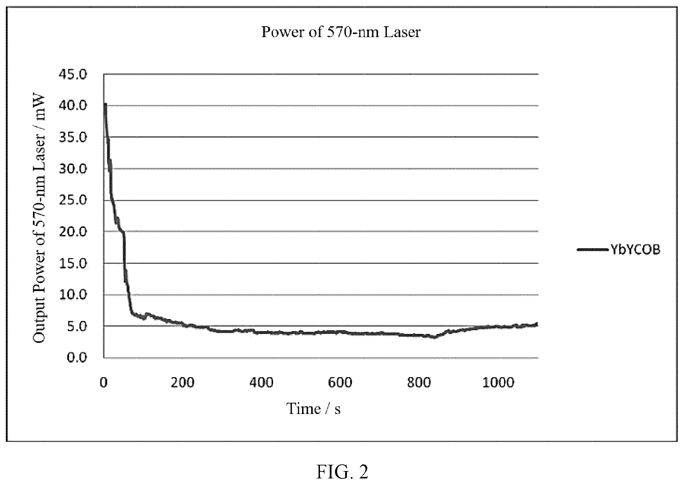

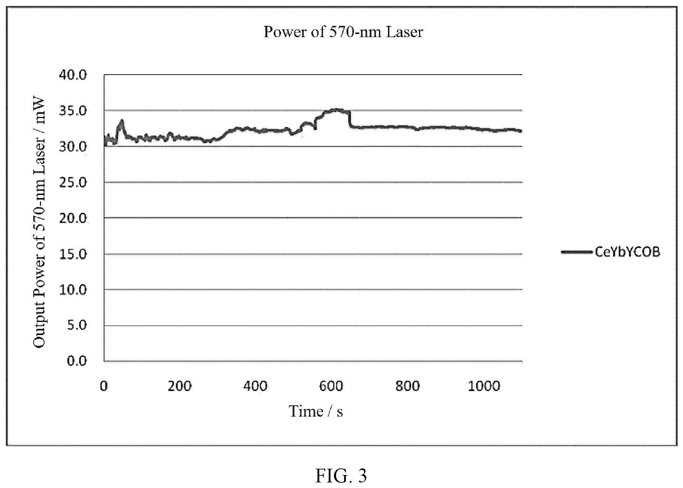

The light output power of both the comparative example and Example 1 was monitored to evaluate the effectiveness of the self-frequency-doubling crystal according to the present application. Specific monitoring results are shown in FIGs. 2 and 3.

It can be seen from FIGs. 2 and 3 that the light output power of the existing yellow laser line projector decreases sharply from approximately 40 mW to about 5 mW within the first 60 s of operation, subsequently stabilizing around 5 mW. In contrast, the yellow laser in Example 1 of the present application maintains its light output power consistently between 30 mW and 35 mW without a significant decease for up to about 1000 s from the beginning of operation. These results demonstrate that the self-frequency-doubling crystal according to the present application can effectively maintain a high yellow light output power, thereby significantly improving luminous efficiency.

The applicant also conducted experimental monitoring on the yellow lasers prepared in other examples, and the monitoring results are similar to those of Example 1 of the present application. The light output power can always be maintained above 30 mW.

The above embodiments are all preferred embodiments of the present application and are not intended to limit the scope of protection of the present application. Therefore, any equivalent changes made based on the structure, shape, and principle of the present application should be covered within the scope of protection of the present application.

## Claims

1. A self-frequency-doubling yellow crystal, **characterised in that** the self-frequency-doubling yellow crystal is doped with tetravalent cerium ions (Ce⁴⁺) at a doping concentration of 0.1% ~ 12% and trivalent ytterbium ions (Yb³⁺) at a doping concentration of 1% ~ 40%.

2. The self-frequency-doubling yellow crystal according to claim 1, **characterised in that** a ratio of the doping concentrations of the tetravalent cerium ions to the trivalent ytterbium ions is controlled within a range of 0.1% ~ 30%.

3. The self-frequency-doubling yellow crystal according to claim 2, **characterised in that** a total doping concentration of the tetravalent cerium ions and the trivalent ytterbium ions is 5%, 10%, or 20%.

4. The self-frequency-doubling yellow crystal according to claim 1, **characterised in that** the crystal is selected from one of yttrium calcium oxyborate crystal, gadolinium calcium oxyborate crystal, gadolinium yttrium calcium oxyborate crystal, yttrium aluminium garnet crystal, gadolinium gallium garnet crystal, yttrium aluminium borate crystal, or fibre optic crystal.

5. The self-frequency-doubling yellow crystal according to claim 4, **characterised in that** the crystal doped with the tetravalent cerium ions and the trivalent ytterbium ions is the yttrium calcium oxyborate crystal with a molecular formula of Ce⁴⁺ₓYb_{y}Y_{1-x-y}Ca₄O(BO₃)₃; a concentration x of the Ce⁴⁺ is 0.1% ~ 12%; a concentration y of the Yb³⁺ is 1% ~ 40%; and a total concentration of the Ce⁴⁺ and the Yb³⁺ is 0.1% ~ 30%.

6. A self-frequency-doubling yellow laser, **characterised in that** the laser comprises the self-frequency-doubling yellow crystal according to claim 1, and further comprises a laser light source and a focusing or light transmission assembly.

7. The self-frequency-doubling yellow laser according to claim 6, **characterised in that** the self-frequency-doubling yellow crystal is cut at an angle along a direction with a maximum nonlinear coefficient of output light.

8. The self-frequency-doubling yellow laser according to claim 6, **characterised in that** the laser light source is a semiconductor pump source with a wavelength of 880 nm ~ 1000 nm.

9. The self-frequency-doubling yellow laser according to claim 6, **characterised in that** an output wavelength of the laser is controlled within a range of 555 nm ~ 630 nm.

10. The self-frequency-doubling yellow laser according to claim 6, **characterised in that** the focusing or light transmission assembly is a focusing lens or optical fibre.
